# EUROPÄISCHE PATENTSCHRIFT

(11) **EP 2 002 492 B1**
(45) Veröffentlichungstag und Bekanntmachung des Hinweises auf die Patenterteilung: **04.01.2012**
(21) Anmeldenummer: 07723337.7
(22) Anmeldetag: 16.03.2007
(51) Int. Cl.: H01L 51/00

(54) **VERWENDUNG VON HETEROCYCLISCHEN RADIKALEN ZUR DOTIERUNG VON ORGANISCHEN HALBEITERN**
USE OF HETEROCYCLIC RADICALS FOR DOPING ORGANIC SEMICONDUCTORS
UTILISATION DE RADICAUX HETEROCYCLIQUES POUR LE DOPAGE DE SEMI-CONDUCTEURS ORGANIQUES

(30) Priorität: 22.03.2006 EP 06005834
(43) Veröffentlichungstag der Anmeldung: 17.12.2008
(73) Patentinhaber: Novaled AG, 01307 Dresden (DE)
(72) Erfinder: ZEIKA, Olaf, 06727 Theissen (DE); LIMMERT, Michael, 01277 Dresden (DE); GRÜSSING, André, 64291 Darmstadt (DE); LUX, Andrea, 01277 Dresden (DE); HARTMANN, Horst, 01326 Dresden (DE); WERNER, Ansgar, 01277 Dresden (DE)
(74) Vertreter: Bittner, Thomas L.
(86) Internationale Anmeldenummer: PCT/EP2007/002359
(87) Internationale Veröffentlichungsnummer: WO 2007/107306

(56) Entgegenhaltungen:
- US-A- 5 922 396
- US-A1- 2005 061 232
- US-A1- 2005 072 971
- VAID T P ET AL: "Investigations of the 9,10-diphenylacridyl radical as an isostructural dopant for the molecular semiconductor 9,10-diphenylanthracene" CHEMISTRY OF MATERIALS, AMERICAN CHEMICAL SOCIETY, WASHINGTON, US, Bd. 15, Nr. 22, 7. Oktober 2003 (2003-10-07), Seiten 4292-4299, XP002355671 ISSN: 0897-4756
- V. WINTGENS ET AL.: "REDUCTION OF PYRYLIUM SALTS: STUDY BY ESR AND UV-VISIBLE SPECTROSCOPY, OF THE REVERSIBLE DIMERIZATION OF THE PYRANLY RADICAL" NEW YOURNAL OF CHEMISTRY, Bd. 10, Nr. 6, 1986, Seiten 345-350, XP008068094 in der Anmeldung erwähnt
- T. MURAMATSU ET AL.: "Preparation and Properties of a Novel Heterocyclic Dispiro Compound, 3,10-Diaza-N,N-dimethyldispiro[5.0.5.3]pen tadeca-1,4,8,11-tetraene" CHEMISTRY LETTERS, 1996, Seiten 151-152, XP008068093 in der Anmeldung erwähnt

## Beschreibung

Die vorliegende Erfindung betrifft die Verwendung von heterocyclischem Radikal oder dessen Dimeren, als Dotand zur Dotierung eines organischen halbleitenden Matrixmaterials oder als Ladungsinjektionsschicht in elektronischen oder optoelektronischen Bauelementen.

Es ist bekannt, organische Halbleiter durch Dotierung hinsichtlich ihrer elektrischen Eigenschaften, insbesondere ihrer elektrischen Leitfähigkeit, zu verändern, wie dies auch bei anorganischen Halbleitern wie Siliciumhalbleitern, der Fall ist. Hierbei wird durch Erzeugung von Ladungsträgern im Matrixmaterial eine Erhöhung der zunächst recht niedrigen Leitfähigkeit sowie je nach Art des verwendeten Dotanden eine Veränderung im Fermi-Niveau des Halbleiters erreicht. Eine Dotierung führt hierbei zu einer Erhöhung der Leitfähigkeit von Ladungstransportschichten, wodurch ohmsche Verluste verringert werden, und zu einem verbesserten Übergang der Ladungsträger zwischen Kontakten und organischer Schicht.

Anorganische Dotanden wie Alkalimetalle (z.B. Cäsium) oder Lewis-Säuren (z.B. FeCl₃) sind bei organischen Matrixmaterialien aufgrund ihrer hohen Diffusionskoeffizienten meist nachteilig, da die Funktion und Stabilität der elektronischen Bauelemente beeinträchtigt wird. Ferner ist es bekannt, Dotanden über chemische Reaktionen in dem halbleitenden Matrixmaterial feizusetzen, um Dotanden hereitzustellen. Das Oxidationspotential der derart freigesetzten Dotanden ist jedoch für verschiedene Anwendungsfälle, wie insbesondere für organische Leuchtdioden (OLED), oftmals nicht ausreichend. Ferner werden bei Freisetzung der Dotanden auch weitere Verbindungen und/oder Atome, beispielsweise atomarer Wasserstoff, erzeugt, wodurch die Eigenschaften der dotierten Schicht bzw. des korrespondierenden elektronischen Bauelementes beeinträchtigt werden.

Ferner haben als Dotanden verwendete Verbindungen oftmals nicht ein ausreichend niedriges Ionisierungspotentiel für den jeweiligen Anwendungsfall.

Aus T.P. Vaid et al., Chem. Mater. 2003, 15, 4292-4299, ist ein Diphenylacridylradikal bekannt, das als Dotand zur Dotierung von 9,10-Diphenylanthracen verwendbar sein soll. Mit dem Diphenylacridylradikal dotierte Schichten aus 9,10-Diphenylanthracen zeigen keine signifikante elektrische Leitfähigkeit bei Raumtemperatur.

Aus der US2005/0072971 A1 ist die Verwendung von heterocyclischen Radikalen als Dotanden bekannt.

Der vorliegenden Erfindung liegt die Aufgabe zugrunde, durch die Verwendung bestimmter heterocycliecher Radikale oder dessen Dimere verbesserte organische halbleitende Matrixmaterialien, oder Ladungsinjektionsschten in elektronischen oder optoelektronischen Bauelementen bereitzustellen. Insbesondere sollen die verwendeten Radikale, und Derivate ausreichend niedrige Oxidationspotentiale aufweisen, ohne störende Einflüsse auf das Matrixmaterial sein und eine wirksame Erhöhung der Ladungstragoranzahi im Matrixmaterial bereitstellen und vergleichsweise einfach handhabbar sein.

Weitere Aufgaben der vorliegenden Erfindung liegen in der Bereitstellung von organischen halbleitenden Materialien und von elektronischen Bauelementen oder optoelektronischen Bauelementen, in denen die offenbarten Radikale verwendet werden können.

Die erste Aufgabe wird durch die Verwendung gemäß Anspruch 1 gelöst. Die weiteren Aufgaben werden durch die Gegenstände der weiteren unabhängigen Ansprüchen gelöst, während bevorzugte Ausführungsformen in den Unteransprüchen wiedergegeben sind.

Im Rahmen der vorliegenden Erfindung werden unter dem Begriff "Dimere" Verbindungen verstanden, die durch Reaktion zweier Monoradikale oder Diradikale miteinander entstehen.

Die Reste R₁₋₉ und R₁₁ können bevorzugt substituiertes Aryl sein, wobei die Substituenten vorzugsweise elektronenschiebende Reste sind, beispielsweise Dialkylamin, Julolidyl, Diarylamin, Alkylarylamin, Diheterocyclylamin, Diheteroalkylamin, Alkoxy, Aryloxy, Alkylmercaptyl, Arylmercaptyl, Alkyl, Sililyl, Halogenakyl, Cycloalkyl, Halogencycloalkyl, Alkenyl, Alkinyl, Trialkylsililylalkinyl oder Styryl.

Überraschenderweise wurde festgestellt, daß bei erfindungsgemäßer Verwendung der offenbarten heterocyclischen Verbindungen ein wesentlich stärkerer und/oder stabilerer Dotand als bei bisher bekannten Donorverbindungen vorliegt, wobei die heterocyclischen Radikale und deren Dimere in neutraler Form als ein n-Dotand gegenüber einem organischen halbleitenden Matrixmaterial eingesetzt werden. Insbesondere wird die Leitfähigkeit von Ladungstransportschichten bei erfindungsgemäßer Verwendung wesentlich erhöht und/oder der Übergang der Ladungsträger zwischen den Kontakten und organischer Schicht bei Anwendungen als elektronisches Bauelement wesentlich verbessert. Ohne durch diese Vorstellung eingeschränkt zu sein, wird davon ausgegangen, dass bei erfindungsgemäβer Verwendung der offenbarten heterocyclischen Verbindungen in einer dotierten Schicht die den jeweiligen heterocyclischen Radikalen zuhörigen Kationen gebildet werden, Insbesondere durch den Transfer von mindestens einem Elektron vom jeweiligen heterocyclischen Radikal und dessen Dimer auf das umgebende Matrixmaterial. Ebenso werden dabei Anionen des Matrixmaterials gebildet, die auf dem Matrixmaterial beweglich sind. Auf diese Weise gewinnt das Matrixmaterial eine Leitfähigkeit, die gegenüber der Leitihhigkeit des undotierten Matrixmaterials erhöht ist. Leitfähigkeiten von undotierten Matrixtnaterialien sind in der Regel < 10⁻⁸ S/cm, insbesondere häufig < 10⁻¹⁰ S/cm. Es ist dabei darauf zu achten, dass die Matrixmaterialien eine genügend hohe Reinheit aufweisen. Solche Reinheiten sind mit herkömmlichen Methoden, zum Beispiel Gradientensublimation zu erreichen. Durch Dotierung last sich die Leitfähigkeit solcher Matrixmaterialien auf größer 10⁻⁸ S/cm, häufig > 10⁻⁶ S/cm erhöhen. Dies gilt insbesondere für Matrixmaterialien, die ein Reduktionspotential von kleiner als -1 V vs. Fc/Fc⁺, bevorzugt kleiner -1.7 V vs. Fc/Fc⁺, insbesondere kleiner -2.1 V vs. Fc/Fc⁺ zeigen. Die Angabe FcFc⁺ bezieht sich auf das Redoxpaar Ferrocen/ Ferrocenium, dass als Referenz in einer elektrochemischen Potentialbestimmung, zum Beispiel Zyklovoltammetrie eingesetzt wird.

Erfindunpgemäß wurde ferner festgestelit daß die beschriebenen heterocyclischen Verbindungen auch als Injektionsschicht in elektronischen Bauteilen, vorzugsweise zwischen einer Elektrode und einer Halbleiterschicht, die auch dotiert sein kann, oder auch als Blockerschicht, vorzugsweise zwischen Emitter- und Transportsohicht, oder als Halbleiterschicht in elektronischen Bauelementen eingesetzt werden können. Die erfindungsgemäße Verwendung ermöglicht eine photo- bzw. lichtinduzierte irreversible Dotierung von organischen Halbleitern mit Hilfe der erfindungsgemäßen Verwendung, insbesondere die Erzeugung der genannten Radikale durch Spaltung ihrer Dimere mittels elektromagnetischer Strahlung und eine nachfolgende irreversible Dotierung von n-leitenden Halbleitern. Bei erfindungsgemäßer Verwendung stellen die beschriebenen heterocyclischen Verbindungen vorzugsweise isolierte Moleküle dar, die somit bevorzugt in der jeweiligen halbleitenden Schicht als isolierte Moleküle vorliegen, die nicht durch chemische Bindungen untereinander und/oder an eine Matrix oder an eine andere Komponente fixiert sind. Die erfindungsgemwsen Dotanden weisen eine überraschend hohe Stabilität in Bezug auf ihre Reaktivität mit der Atmosphäre auf.

### Syntheseverfahren

Die Radikale und Derivate derselben lassen sich nach bekannten Verfahren synthetisieren, teilweise sind sie auch kommerziell erhältlich. Die Synthese solcher Verbindungen ist beispielsweise in folgenden Literaturstellen beschrieben, die hiermit jeweils vollumfänglich als Referenz in der Anmeldung mit eingeschlossen sind. Es versteht sich, dass die genannten Literaturstellen nur beispielhaft angegeben sind.

Benzimidazole können unter anderem leicht aus o-Phenylendiamin und entsprechenden Carbonsäurederivaten M.R. DeLuca, S.M.Kerwin Tetrahedron 53 457-64 (1997) oder Aldehyden (M.Curini et al. Synlett 10 1832-4 2004) synthetisiert werden. Siehe auch: M.R.Grimmett "Imidazole and Benzimidazole Synthesis" Academic Press; Harcourt Brace & Company, Publishers, London, San Diego, New York, Boston, o-Phenylendiamine sind käuflich oder beispielsweise nach der Methode von Suschitsky et al., J.C.S.Chem. Comm. 1977 189-90, darstellbar. Eine Darstellung von Benzthiazolen kann in Analogie' über die o-Mercaptoaniline dargestellt werden.

Perarylierte Imidazole lassen sich nach H.Baumgärtel et al. aus Benzoinen, Anilinen und Benzoesäurechlorid herstellen (Ber. Bunsenges. (1972) 76/2 94-100; Chem. Ber. (1968) 101 3504).

Die Alkylierungen der bzw. des N-Atoms in den heterocyclischen Fünfringen gelingt mit Dimethyl- bzw. Diethylsulfat in Gegenwart von Basen, H. Quast, E. Schmitt Chem. Ber. 101 4012-14 (1968) oder mit Alkylhalogeniden. Die entsprechenden kationischen Produkte (Heteroarenium-Verbindungen) können als Perchlorat, Tetrafluoroborat, Halogenid, Tetraphenylborat oder Hexafluorophosphat isoliert werden.

Die oben genannten Radikale lassen sich chemisch mittels Alkalimetallen bzw. den Alkalimetallamalgamen oder elektrochemisch aus den entsprechenden heteroaromatischen Kationen durch Reduktion herstellen, T.Muramatsu et al. Chemistry Letters 1996 151-2;Pragst et al. J. Electroanal. Chem., 180 1984 141-56; V.Wintgens, J.Pouliquen, J.Kossanyi, New J.Chem. 1986 10/6 345-50. In der Regel dimerisieren bzw. polymerisieren die Radikale jedoch rasch oder bilden Dispiroverbindungen **b** sowie Tricyclen d, T.Muramatsu, A.Toyota, M.Suzuki, J. Am. Chem. Soc. 2005 127 4572-3; T.Muramatsu, Y.Ikegami, K.Hanaya, J. Am. Chem. Soc. 1989 111 5782-7. Die Lage des Gleichgewichtes hängt auch von der Länge und Art der Brücke und damit der Ringspannung, sowie dem energetischen Zustand insbesondere der Temperatur ab.

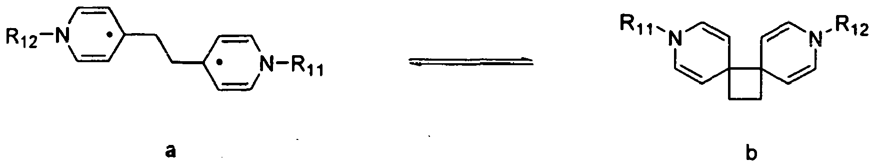

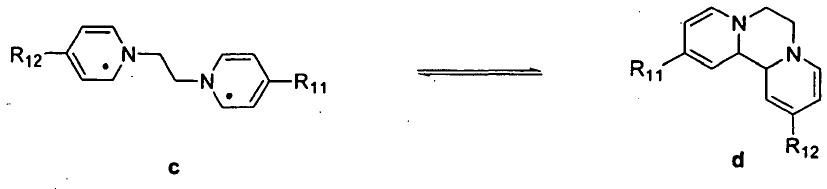

Bis-[3-methyl-2-alkyl-1,2-dihydro-benzthiazolyl-(2)]-und Bis-[3-methyl-2-aryl-1,2-dihydro-benzthiazolyl-(2)]-Verbindungen lassen sich direkt über Benzthiazoliumsalze und entsprechende Grignard-Verbindungen darstellen, A.Kinya; S, Hiroaki; I. Naoki; Bull. Chem. Soc. Japan (1979) 52/1 156-9.

Einige besonders stabile Radikale, z.B. Pyridylradikale, lassen sich auch so isolieren, W.M.Schwarz, E.M,Kosower, I.Shain,J. Am.Chem.Soc. 33 3164 (1961)

### Dotierung

Als n-dotierbare Matrixmaterialen können unter anderem Quinolinatokomplexe, beispielsweise des Aluminiums oder anderer Hauptgruppenmetalle, wobei der Quinolinatoligand auch substituiert sein kann, eingesetzt werden. Insbesondere kann das Matrixmaterial Tris(8-hydroxy-quinolinato)-aluminium sein. Auch andere Aluminiumkomplexe mit O- und/oder N-Donoratomen können gegebenenfalls eingesetzt werden.

| | |
|---|---|
| 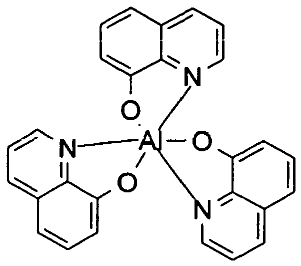 | 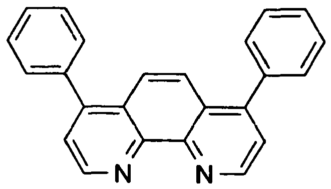 |
| tris (8-hdroxy-quinolinato)-aluminium | BPhen= bathophenanthroline (4,7-Diphenyl-1, 1 0-phenanthroline) C24H16N2 |
| | |
| 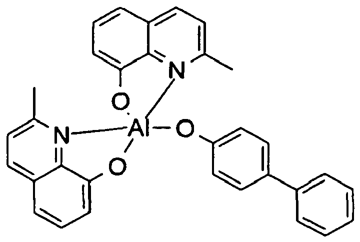 | |
| Bis-(2-methyl-8-quinolinolato)-4-(phenyl-phenolato)-aluminium-(III) | |

Die Quinolinatokomplexe können beispielsweise einen, zwei oder drei Quinolinatoliganden enthalten, wobei die anderen Liganden vorzugsweise mit O- und/oder N-Donoratomen an das Zentralatom komplexieren, wie beispielsweise obenstehender Al-Komplex.

Als Matrixmaterial können auch Phenanthroline eingesetzt werden, die substituiert oder unsubstituiert sein können, insbesondere Aryl-substituiert, beispielsweise Phenyl- oder Naphthyl-substituiert. Insbesondere kann Bphen als Matrixmaterial eingesetzt werden.

Als Matrixmaterial können auch Heteroaromaten wie insbesondere Triazole eingesetzt werden, gegebenenfalls auch Pyrrole, Imidazole, Triazole, Pyridine, Pyrimidine, Pyridazine und dergleichen. Die Heteroaromaten sind vorzugsweise substituiert, insbesondere Aryl-substituiert, beispielsweise Phenyl- oder Naphthyl-substituiert. Insbesondere kann untenstehendes Triazol als Matrixmaterial eingesetzt werden.

| |
|---|
| 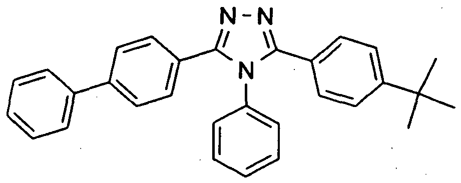 |
| 3-(4-Biphenylyl)-4-phenyl-5-tert-butylphenyl-1,2,4-triazole C30H27N3 |

Vorzugsweise besteht das verwendete Matrixmaterial vollständig aus einem Metallphthalocyanin-Komplex, insbesondere ZnPc, einem Porphyrin-Komplex, oder einem Buckminster-Fulleren, insbesondere Fulleren C60.

Es versteht sich, dass die genannten Matrixmaterialien auch untereinander oder mit anderen Materialien gemischt im Rahmen der Erfindung einsetzbar sind. Es versteht sich, dass auch geeignete andere organische Matrixmaterialien verwendet werden können, die halbleitende Eigenschaften aufweisen.

### Dotierungskonzentration

Vorzugsweise liegt der Dotand in einer Dotierungskonzentration von ≤ 1:1 zu dem Matrixmolekül bzw. der monomeren Einheit eines polymeren Matrixmoleküls vor, vorzugsweise in einer Dotierungskonzentration von 1:2 oder kleiner, besonders bevorzugt von 1:5 oder kleiner oder 1:10 oder kleiner. Die Dotierungskonzentration kann sich in dem Bereich von 1:1 bis 1:100.000, insbesondere in dem Bereich von 1:5 bis 10.000 oder 1:10 bis 1.000 betragen, beispielsweise in dem Bereich von 1:10 bis 1:100 oder 1:25 bis 1:50, ohne hierauf beschränkt zu sein.

### Durchführung der Dotierung

Die Dotierung des jeweiligen Matrixmaterials mit den erfindungsgemäß zu verwendenden Verbindungen kann durch eines oder eine Kombination der folgenden Verfahren erfolgen:
a) Mischverdampfung im Vakuum mit einer Quelle für das Matrixmaterial und einer für den Dotanden.
b) Sequentielles Deponieren des Matrixmaterials und des n-Dotanden auf einem Substrat mit anschliessender Eindiffusion des Dotanden, insbesondere durch thermische Behandlung.
c) Dotierung einer Matrixschicht durch eine Lösung von n-Dotanden mit anschliessendem Verdampfen des Lösungsmittels, insbesondere durch thermische Behandlung.
d) Oberflächendotierung einer Matrixmaterialschicht durch eine oberflächlich aufgebrachte Schicht von Dotanden.
e) Herstellung einer Lösung von Matrixmolekülen und Dotanden und anschließende Herstellung einer Schicht aus dieser Lösung mittels konventioneller Methoden wie beispielsweise Verdampfen des Lösungsmittels oder Aufschleudern

Die Dotierung kann gegebenenfalls auch derart erfolgen, dass der Dotand aus einer Precursor-Verbindung heraus verdampft wird, die beim Erhitzen und/oder Bestrahlen den Dotanden freisetzt. Als Precursor-Verbindung kann beispielsweise jeweils eine Carbonylverbindung, Distickstoffverbindung oder dergleichen eingesetzt werden, die bei der Freisetzung des Dotanden CO, Stickstoff oder dergleichen abspaltet, wobei auch andere geeignete Precursor einsetzbar sind, wie beispielsweise Salze, z.B. Halogenide, oder dergleichen. Die Auswahl solcher Precursor-Verbindung kann sich danach richten, dass der Dotand in dieser Verbindung nicht als Radikal vorliegt. Dies kann die Handhabbarkeit des Dotanden verbessern. Die Bestrahlung kann mittels elektromagnetischer Strahlung, insbesondere sichtbarem Licht, UV-Licht oder IR-Licht erfolgen, beispielsweise jeweils Laserlicht, oder auch durch andere Strahlungsarten. Durch die Bestrahlung kann im wesentlichen die zur Verdampfung notwendige Wärme bereitgestellt werden, es kann auch gezielt in bestimmte Banden der zu verdampfenden Verbindungen bzw. Precursor oder Verbindungskomplexe wie Charge-Transfer-Komplexe eingestrahlt werden, um beispielsweise durch Überführung in angeregte Zustände die Verdampfung der Verbindungen durch Dissoziation der Komplexe zu erleichtern. Der Komplex kann aber insbesondere auch ausreichend stabil sein, um unter den gegebenen Bedingungen undissoziiert zu verdampfen oder auf das Substrat aufgebracht zu werden. Es versteht sich, dass auch andere geeignete Verfahren zur Durchführung der Dotierung eingesetzt werden können.

Auf diese Weise können somit n-dotierte Schichten von organischen Halbleitern hergestellt werden, die vielfältig einsetzbar sind.

### Halbleitende Schicht

Mittels der erfindungsgemäß verwendeten elektronenreichen Radikale, Diradikale und deren Derivate können halbleitende Schichten erzeugt werden, die gegebenenfalls eher linienförmig ausgebildet sind, wie z.B. als Leitfähigkeitspfade, Kontakte oder dergleichen. Die Verbindungen können hierbei als n-Dotanden zusammen mit einer anderen Verbindung, die als Matrixmaterial fungieren kann, eingesetzt werden, wobei das Dotierungsverhältns 1 : 1 oder kleiner sein kann. Der verwendete Dotand kann zu der jeweils anderen Verbindung bzw. Komponente aber auch in höheren Anteilen vorliegen, so dass das Verhältnis Dotand : Verbindung im Verhältnis > 1 : 1 liegen kann, beispielsweise im Verhältnis ≥ 2 : 1, ≥ 5 : 1, ≥10 : 1 oder ≥ 20 : 1 oder höher. Die jeweils andere Komponente kann eine solche sein, wie sie als Matrixmaterial im Falle der Herstellung dotierter Schichten eingesetzt werden kann, ohne hierauf beschränkt zu sein. Gegebenenfalls kann der verwendete Dotanden auch im wesentlich in reiner Form vorliegen, beispielsweise als reine Schicht.

Der einen Dotanden enthaltende oder im wesentlichen oder vollständig aus diesem bestehende Bereich kann insbesondere mit einem organischen halbleitenden Material und/oder einem anorganischen halbleitenden Material elektrisch stromleitend kontaktiert sein, beispielsweise auf einem derartigen Substrat angeordnet sein.

Vorzugsweise werden die genannten elektronenreichen Radikale, Diradikale und Derivate erfindungsgemäß als n-Dotanden eingesetzt, z.B. in einem Verhältnis ≤ 1 : 1 oder ≤ 1 : 2. Mittels der erfindungsgemäß als n-Dotanden eingesetzten elektronenreichen Verbindungen können beispielsweise bei der Verwendung von Fulleren C₆₀ als Matrix halbleitende Schichten mit Leitfähigkeiten bei Raumtemperatur in dem Bereich von 10⁻⁵ S/cm oder höher erzielt werden, beispielsweise von 10⁻³ S/cm oder höher, beispielsweise von 10⁻¹ S/cm. Bei der Verwendung von Phthalocyanin-Zink als Matrix wurde eine Leitfähigkeit von höher 10⁻⁸ S/cm erzielt, beispielsweise 10⁻⁶ S/cm. Bisher war es nicht möglich, diese Matrix mit organischen Donoren zu dotieren, da das Reduktionspotential der Matrix zu gering ist. Die Leitfähigkeit von undotiertem Phthalocyanin-Zink beträgt hingegen maximal 10⁻¹⁰ S/cm.

Es versteht sich, dass die Schicht oder das Gebilde mit den Dotanden jeweils ein oder mehrere verschiedene derartige elektronenreiche Radikale, Diradikale und Derivate enthalten kann.

### Elektronisches Bauelement

Unter Verwendung der beschriebenen Verbindungen zur Herstellung n-dotierter organischer halbleitender Materialien, die insbesondere in Form von Schichten oder elektrischen Leitungspfaden angeordnet sein können, können eine Vielzahl elektronischer Bauelemente oder diese enthaltende Einrichtungen mit einer n-dotierten organischen Halbleiterschicht hergestellt werden. Im Sinne der Erfindung werden von dem Begriff "elektronische Bauelemente" auch optoelektronische Bauelemente mit umfasst. Durch die beschriebenen Verbindungen können die elektronischen Eigenschaften eines elektronisch funktionell wirksamen Bereichs des Bauelementes, wie dessen elektrische Leitfähigkeit, lichtemittierende Eigenschaften oder dergleichen, vorteilhaft verändert werden. So kann die Leitfähigkeit der dotierten Schichten verbessert und/oder die Verbesserung der Ladungsträgerinjektion von Kontakten in die dotierte Schicht erreicht werden.

Die Erfindung umfasst insbesondere organische lichtemitierende Dioden (OLED), organische Solarzellen, Feldeffekt-Transistoren organische Dioden, insbesondere solche mit hohem Gleichrichtungsverhältnis wie 10³-10⁷, vorzugsweise 10⁴-10⁷ oder 10⁵-10⁷, und organische Feldeffekttransistoren, die mittels der elektronenreichen Radikale und deren Derivate hergestellt sind.

In dem elektronischen Bauelement kann eine n-dotierte Schicht auf Basis eines organischen Matrixmaterials beispielsweise in folgenden Schichtstrukturen vorliegen, wobei vorzugsweise die Basismaterialien oder Matrixmaterialien der einzelnen Schichten jeweils organisch sind:
M-i-n: Metall-Isolator-n-dotierter Halbleiter, wobei die Schicht M den Metallgrundkontakt bildet und beispielsweise ITO, Au, Ag, Al usw. sein kann. Der Deckkontakt bildet mit der n-dotierten Schicht einen ohmschen Kontakt und kann beispielsweise aus Al bestehen. Die Schicht "i" steht für eine undotierte Schicht.
n-i-M: es gelten die Ausführungen zur M-i-n Struktur, im Unterschied hierzu ist jedoch der ohmsche Kontakt auf dem Substrat vorgesehen.
p-i-n: p-dotierter Halbleiter-Isolator-n-dotierter Halbleiter,
n-i-p: n-dotierter Halbleiter-Isolator-p-dotierter Halbleiter.

"i" ist wiederum eine undotierte Schicht, "p" ist eine p-dotierte Schicht. Die Kontaktmaterialien sind hier löcherinjizierend, wobei p-seitig beispielsweise eine Schicht oder ein Kontakt aus ITO oder Au vorgesehen sein kann, oder elektroneninjizierend, wobei n-seitig eine Schicht oder ein Kontakt aus ITO, Al oder Ag vorgesehen sein kann.

In obigen Strukturen kann im Bedarfsfall auch die i-Schicht ausgelassen werden, wodurch Schichtenabfolgen mit p-n oder n-p-Übergängen erhalten werden können.

Die Verwendung der beschriebenen Verbindungen ist jedoch auf die oben genannten Ausführungsbeispiele nicht beschränkt, insbesondere können die Schichtstrukturen durch Einführung zusätzlicher geeigneter Schichten ergänzt bzw. modifiziert werden. Insbesondere können jeweils OLEDs mit derartigen Schichtabfolgen, insbesondere mit pin- oder mit einer dazu inversen Struktur, mit den beschriebenen Verbindungen aufgebaut werden.

Mit Hilfe der beschriebenen n-Dotanden können insbesondere organische Dioden vom Typ Metall-Isolator-n-dotierte Halbleiter (min) oder auch gegebenenfalls vom pin-Typ hergestellt werden, beispielsweise auf der Basis von Phthalozyaninzink. Diese Dioden zeigen ein Rektifizierungsverhaltnis von 10⁵ und höher. Ferner können unter Verwendung der erfindungsgemäßen Dotanden elektronische Bauelemente mit p-n-Übergängen erzeugt werden, wobei für die p- und die n-dotierte Seite jeweils dasselbe Halbleitermatenal verwendet wird (Homo-p-n-Übergang), und wobei für das n-dotierte Halbleitermaterial ein beschriebenes elektronerneiches Radikal oder dessen Derivat eingesetzt wird.

Die elektronenreichen Radikale und Derivate können erfindungsgemäß in den elektronischen Bauelementen aber auch in Schichten, Leitfähigkeitspfaden, Punktkontakten oder dergleichen eingesetzt werden, wenn diese gegenüber einer anderen Komponente überwiegen, beispielsweise als Injektionsschicht in reiner oder im wesentlichen reiner Form.

Weitere Aufgaben und Vorteile der vorliegenden Erfindung werden nun anschaulich anhand der folgenden Beispiele beschrieben, die lediglich veranschaulichend und nicht als den Umfang der Erfindung begrenzend zu betrachten sind.

### Anwendungsbeispiele

Es werden ein äußerst elektronenreiches Radikal oder dessen Dimer bereitgestellt.

Das vorgelegte Radikal oder Diner wird gleichzeitig mit dem Matrixmaterial verdampft. Gemäß dem Ausfühiungsbeispiel ist das Matrixmaterial jeweils Phthalozyanin-Zink oder Fulleren C₆₀. Der n-Dotand und Matrixmaterial können derart verdampft werden, dass die auf einem Substrat in einer Vakuumverdampfungsanlage niedergeschlagene Schicht ein Dotierungsverhältnis von n-Dotand zu Matrixmaterial von 1:10 aufweist.

Die jeweils mit dem n-Dotanden dotierte Schicht des organischen Halbleitermaterials ist auf einer. ITO-Schicht (Indiumzinnoxid) aufgebracht, welche auf einem Glassubstrat angeordnet ist. Nach Aufbringung der n-dotierten organischen Halbleiterschicht wird eine Metallkathode aufgebracht, beispielsweise durch Aufdampfung eines geeigneten Metalls, um eine organische Leuchtdiode herzustellen. Es versteht sich, dass die organische Leuchtdiode auch einen sogenannten invertierten Schichtaufbau haben kann, wobei die Schichtenabfolge ist: Glassubstrat - Metallkathode -n-dotierte organische Schicht - transparente leitende Deckschicht (beispielsweise ITO). Es versteht sich, dass je nach Anwendungsfall zwischen den einzelnen genannten Schichten weitere Schichten vorgesehen sein können. Am Ende des Verdampfungsvorganges wurden einige Devices mit UV-Strahlung belichtet, wonach ein irreversibler Leitfähigkeitsanstieg festgestellt werden konnte. Hier können beispielsweise Halogenlampen oder Quecksilberdrucklampen zum Einsatz kommen.

### Beispiel 1:

Das neutrale Dimer 1,1',2,2',4,4',6,6'-Octamethyl-4,4'-bis[1,4-dihydropyridinyl-(4)] wurde zur Dotierung von ZnPc als Matrixmaterial verwandt. Dotierte Schichten mit einem Dotierungsverhältnis Dotand : Matrixmaterial von 1 : 10 wurden durch Mischverdampfung von Matrix und Dotand mit ZnPc hergestellt. Das Reduktionspotential von ZnPc beträgt ca. -1.3V vs. Fc/Fc⁺.

Die Leitfähigkeit betrug 9x10⁻⁵S/cm.

### Beispiel 2:

Das Fulleren C60 wurde mit dem 1,3-Di-(4-anisyl)-2,4,5-triphenylimidazolyl-Radikal im Verhältnis 10:1 dotiert. Die Leitfähigkeit lag bei 2x10⁻⁵S/cm. Das Reduktionspotential von C60 beträgt ca. -1.0V vs. Fc/Fc⁺.

### Beispiel 3:

Das neutrale Dimer 2,2',4,4',6,6-Hexamethyl-4,4'-bi-4H-pyran wurde durch konventionelle Verfahren hergestellt.

Das Dimer wurde dann mit C60 als Matrixmaterial in eine Verdampferquelle gefüllt. Dotierte Schichten mit einem Dotierungsverhältnis Dotand : Matrixmaterial von 1:10 wurden durch Mischverdampfung von Matrix und Dotand mit C60 hergestellt.

Die Leitfähigkeit lag bei 3x 10⁻⁵S/cm.

### Beispiel 4:

Das neutrale Dimer Bis-[1,2,3-trimethyl-1,2-dihydro-benzimidazolyl-(2)]wurde durch konventionelle Verfahren hergestellt.

Das Dimer wurde dann mit ZnPc als Matrixmaterial in eine Verdampferquelle gefüllt. Dotierte Schichten mit einem Dotierungsverhältnis Dotand : Matrixmaterial von 1 : 10 wurden durch Mischverdampfung von Matrix und Dotand mit ZnPc hergestellt.

Die Leitfähigkeit lag bei 6x10⁻⁴S/cm.

### Beispiel 5:

Das neutrale Dimer Bis-[1,2,3-trimethyl-1,2-dihydro-benzimidazolyl-(2)] wurde durch konventionelle Verfahren hergestellt.

Das Dimer wurde dann mit C60 als Matrixmaterial in eine Verdampferquelle gefüllt. Dotierte Schichten mit einem Dotierungsverhältnis Dotand : Matrixmaterial von 1 : 10 wurden durch Mischverdampfung von Matrix und Dotand mit C60 hergestellt.

Die Leitfähigkeit lag bei 2x 10⁻³S/cm.

### Beispiel 6:

Das neutrale Dimer Bis-[1,2,-dimethyl-1,2-dihydro-benzthiazolyl-(2)] wurde durch konventionelle Verfahren hergestellt. Das Dimer wurde dann mit C60 als Matrixmaterial in eine Verdampferquelle gefüllt. Dotierte Schichten mit einem Dotierungsverhältnis Dotand : Matrixmaterial von 1:10 wurden durch Mischverdampfung von Matrix und Dotand mit C60 hergestellt.

Die Leitfähigkeit lag bei 3x10⁻⁴S/cm.

Die in der vorstehenden Beschreibung und den Ansprüchen offenbarten Merkmale der Erfindung können sowohl einzeln als auch in jeder beliebigen Kombination für die Verwirklichung der Erfindung in ihren verschiedenen Ausführungsformen wesentlich sein.

## Patentansprüche

1. Verwendung von heterocyclischem Radikal oder dessen Dimeren als Dotand zur Dotierung eines organischen halbleitenden Matrixmaterials oder als Ladungsinjektionsschicht in elektronischen oder optoelektronischen Bauelementen, **dadurch gekennzeichnet, dass** das heterocyclische Radikal eine Struktur gemäß der folgenden Formel aufweist: 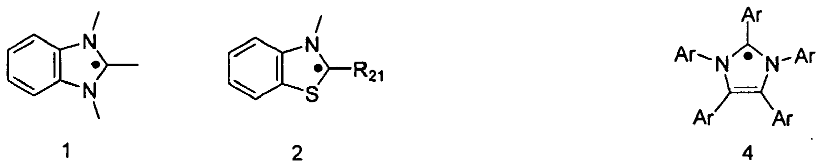 wobei Ar unabhängig voneinander Phenyl, Anisyl oder Tosyl ist; und R₂₁ Methyl, Ethyl, Butyl, Phenyl, 4-Tosyl, 4-Anisyl oder 4-Chlorphenyl ist.

2. Verwendung nach einem der vorangehenden Anspruch 1, **dadurch gekennzeichnet, dass** die heterocyclische Verbindung als Kation vorliegt.

3. Organisches halbleitendes Material enthaltend zumindest eine organische Matrixverbindung und einen Dotanden, **dadurch gekennzeichnet, dass** als Dotand zumindest eine Verbindung gemäß den Ansprüchen 1 oder 2 verwendet wird.

4. Organisches halbleitendes Material nach Anspruch 3, **dadurch gekennzeichnet, dass** das molare Dotierungsverhältnis von Dotand zu Matrixmolekül bzw. das Dotierungsverhältnis von Dotand zu monomeren Einheiten eines polymeren Matrixmoleküls zwischen 20:1 und 1:100.000, bevorzugt 10:1 und 1:1000, besonders bevorzugt 1:1 und 1:100, beträgt.

5. Organisches halbleitendes Material nach einem der Ansprüche 3 oder 4, **dadurch gekennzeichnet, dass** der Dotand als Kation vorliegt.

6. Elektronisches oder optoelektronisches Bauelement mit einem elektronisch funktionell wirksamen Bereich, **dadurch gekennzeichnet, dass** für den elektronisch wirksamen Bereich zumindest eine Verbindung der Ansprüche 1 oder 2 verwendet wird.

7. Elektronisches oder optoelektronisches Bauelement nach Anspruch 6, **dadurch gekennzeichnet, dass** der elektronisch wirksame Bereich ein organisches halbleitendes Matrixmaterial aufweist, welches mit zumindest einem Dotanden zur Veränderung der elektronischen Eigenschaften des halbleitenden Matrixmaterials unter Verwendung zumindest einer Verbindung der Ansprüche 1 oder 2 dotiert wird.

8. Elektronisches oder optoelektronisches Bauelement nach Anspruch 6 oder 7 in Form einer organischen Licht-emittierenden Diode, einer photovoltaischen Zelle, einer organischen Solarzelle, einer organischen Diode, eines organischen Feldeffekttransistors oder eines photoinitiierten bzw. magnetischen Speichers.

9. Elektronsiches oder optoelektronisches Bauelement nach einem der vorangehenden Ansprüche 6 bis 8, **dadurch gekennzeichnet, dass** die heterocyclische Verbindung als Kation vorliegt.

## Claims

1. Use of a heterocyclic radical or its dimers as a dopant for doping an organic semiconductive matrix material or as a charge injection layer in electronic or optoelectronic devices, **characterised in that** the heterocyclic radical has a structure in accordance with the following formula: 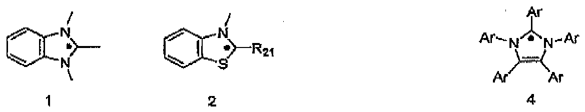 wherein Ar is, independently of another, phenyl, anisyl or tosyl; and R₂₁ is methyl, ethyl, butyl, phenyl, 4-tosyl, 4-anisyl or 4-chlorophenyl.

2. Use according to claim 1, **characterized in that** the heterocyclic compound is present as cation.

3. Organic semiconductive material containing at least one organic matrix compound and a dopant, **characterised in that** at least one compound according to claims 1 to 2 is used as the dopant.

4. Organic semiconductive material according to claim 3, **characterised in that** the molar doping ratio of dopant to matrix molecule or the doping ratio of dopant to monomeric units of polymeric matrix molecule is between 20:1 and 1:100,000, preferably 10:1 and 1:1,000, particularly preferably 1:1 and 1:100.

5. Organic semiconductive material according to any of the claims 3 or 4, **characterised in that** the dopant is present as cation.

6. Electronic or optoelectronic device with a region effective in terms of its electronic functions, **characterised in that** at least one compound according to claims 1 or 2 is used for the electronically effective region.

7. Electronic or optoelectronic device according to claim 6, **characterised in that** the electronically effective region has an organic semiconductive matrix material which is doped with at least one dopant to change the electronic properties of the semiconductive matrix material by using at least one compound according to claims 1 or 2.

8. Electronic or optoelectronic device according to claim 6 or 7 in the form of an organic light-emitting diode, a photo-voltaic cell, an organic solar cell, an organic diode, an organic field-effect transistor or a photo-initiated or magnetic memory.

9. Electronic or optoelectronic device according to any of the preceding claims 6 to 8, **characterized in that** the heterocyclic compound is present as cation.

## Revendications

1. Utilisation d'un radical hétérocyclique ou de ses dimères en tant que dopant destiné au dopage d'un matériau de matrice semi-conducteur organique ou en tant que couche d'injection de charges dans des composants électroniques ou optoélectroniques, **caractérisée en ce que** ledit radical hétérocyclique présente une structure selon la formule suivante : 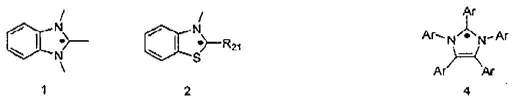 dans laquelle Ar signifie, de façon indépendante, phényle, anisyle ou tosyle; et R₂₁ signifie méthyle, méthyle, butyle, phényle, 4-tosyle, 4-anisyle ou 4-chlorophényle.

2. Utilisation selon la revendication 1 précédente, **caractérisée en ce que** le composé hétérocyclique se présente sous la forme d'un cation.

3. Matériau semi-conducteur organique, contenant au moins un composé de matrice organique et un dopant, **caractérisé en ce que** l'on utilise, en tant que dopant, au moins un composé selon les revendications 1 ou 2.

4. Matériau semi-conducteur organique selon la revendication 3, **caractérisé en ce que** le rapport molaire de dopage entre le dopant et la molécule de matrice ou, le cas échéant, le rapport de dopage entre le dopant et des unités monomères d'une molécule de matrice polymère, se situe entre 20 : 1 et 1 : 100 000, de préférence entre 10 : 1 et 1 : 1 000, avec une préférence particulière entre 1 : 1 et 1 : 100.

5. Matériau semi-conducteur organique selon l'une des revendications 3 ou 4, **caractérise en ce que** le dopant se présente sous la forme d'un cation.

6. Composant électronique ou optoélectronique avec une partie présentant une fonctionnalité électronique, **caractérisé en ce que** l'on utilise au moins un composé des revendications 1 ou 2 pour ladite partie présentant une fonctionnalité électronique.

7. Composant électronique ou optoélectronique selon la revendication 6, **caractérisé en ce que** ladite zone présentant une fonctionnalité électronique comporte un matériau de matrice semi-conducteur qui est dopé avec au moins un dopant afin de modifier les propriétés électroniques dudit matériau de matrice semi-conducteur, en utilisait au moins un composé des revendications 1 ou 2.

8. Composant électronique ou optoélectronique selon la revendication 6 ou 7 sous la forme d'une diode électroluminescente organique, d'une cellule photovoltaïque, d'une cellule solaire organique, d'une diode organique, d'un transistor à effet de champ organique ou d'une mémoire à photo-initiation et/ou magnétique.

9. Composant électronique ou optoélectronique selon l'une des revendications 6 à 8 précédentes, **caractérisé en ce que** ledit composé hétérocyclique se présente sous la forme d'un cation.
